# EUROPEAN PATENT APPLICATION

(11) **EP 4 632 485 A2**
(43) Date of publication of application: **15.10.2025**
(21) Application number: 25165943.9
(22) Date of filing: 25.03.2025
(51) Int. Cl.: G03F 7/00

(54) **PLANARIZATION APPARATUS AND ARTICLE MANUFACTURING METHOD**

(30) Priority: 10.04.2024 JP 2024063538
(71) Applicant: CANON KABUSHIKI KAISHA, Tokyo 146-8501 (JP)
(72) Inventor: TODA, Shun, Tokyo, 146-8501 (JP); TORII, Hirotoshi, Tokyo, 146-8501 (JP)
(74) Representative: TBK

(57) **Abstract**

A planarization apparatus includes a plurality of processors including first and second processors and configured to perform a planarization process of a substrate in each of the processors. The first processor is arranged within a conveyance range of one of the substrate and the flat member by a first conveyance robot arranged on the conveyance path between a loading unit and an adjuster and configured to convey one of the substrate and the flat member. The second processor is arranged within a conveyance range of one of the substrate and the flat member by a second conveyance robot arranged on the conveyance path between the adjuster and the supplier and configured to convey one of the substrate and the flat member.

## Description

### BACKGROUND OF THE INVENTION

### Field of the Invention

The present invention relates to a planarization apparatus and an article manufacturing method.

### Description of the Related Art

As a method of manufacturing an article such as a semiconductor device or MEMS, there is known an imprint method of forming an imprint material on a substrate by using a mold. An imprint technique is a microfabrication technique for forming a pattern of a cured product onto which a concave/convex pattern of a mold is transferred by bringing the mold into contact with an imprint material supplied onto a substrate and applying curing energy to the imprint material.

There is also proposed a technique for planarizing the surface of a substrate by using an imprint technique (see Japanese Patent Laid-Open No. 2011-529626). There is conventionally provided a technique for planarizing the step of the surface of a substrate by forming a coating film on the substrate using an existing coating apparatus (spin coater). However, this technique is insufficient to planarize the step of the surface of the substrate on a nanoscale basis. On the other hand, in the technique disclosed in Japanese Patent Laid-Open No. 2011-529626, it is possible to improve the accuracy of planarization by supplying a polymerizable material based on the step of a substrate and curing the polymerizable material while a template having a flat surface is in contact with the supplied polymerizable material.

In a planarization process proposed in Japanese Patent Laid-Open No. 2011-529626, a substrate is planarized through a supply step, a contact step, a curing step, and a separation step. A planarization apparatus differs from an imprint apparatus in that it brings a flat member (called a "superstrate") on which no pattern is formed into contact with a composition supplied to the entire region of the surface of a substrate and collectively cures the composition in this state.

Therefore, the curing time of the composition supplied to the entire region of the surface of the substrate in the planarization apparatus is longer than that in the imprint apparatus. In addition, the planarization apparatus requires a large amount of curing energy, and the adhesive force acting when the flat member is brought into contact with and separated from the composition supplied to the entire region of the surface of the substrate is as high as the order of several hundred N. Thus, the above contact step, curing step, and separation step may each require several 10 sec, and it takes much time for a planarization process per substrate after the composition supply step. If four steps in the planarization process are sequentially processed, the throughput of the planarization apparatus is limited to several 10 substrates per hour at most. In order to improve the productivity of the planarization apparatus, there is a need to minimize the processing time for each step or cluster planarization apparatuses to concurrently process a plurality of substrates.

Japanese Patent Laid-Open No. 2016-149576 discloses a processing apparatus in which a plurality of coating processors for applying an organic material onto substrates and a plurality of heat-treatment units for performing heating processes for the substrates are arranged and clustered.

With respect to the planarization apparatus as well, it is considered to cluster processors for performing a composition supply process, a contact process, a curing process, and a separation process. However, clustering of the simple processors increases the footprint of the apparatus. In addition, if processors are clustered, the conveyance destinations of a substrate increase, thereby increasing the load of a conveyance mechanism and decreasing throughput.

### SUMMARY OF THE INVENTION

The present invention provides a technique advantageous in reducing the footprint of a planarization apparatus and improving throughput.

The present invention in its first aspect provides a planarization apparatus as specified in claims 1 to 17.

The present invention in its second aspect provides an article manufacturing method as specified in claim 18.

Further features of the present invention will become apparent from the following description of exemplary embodiments (with reference to the attached drawings).

### BRIEF DESCRIPTION OF THE DRAWINGS

Fig. 1 is a view showing the configuration of a planarization apparatus;
Figs. 2A and 2B are views respectively showing a loading unit and a placement unit;
Fig. 3 is a view for explaining a process of conveying a substrate from the loading unit to a supplier;
Fig. 4 is a view for explaining a process of conveying the substrate from the supplier to a processor;
Fig. 5 is a view for explaining a process of conveying the substrate from the processor to the loading unit;
Fig. 6 is a timing chart of conveyance of a plurality of substrates;
Figs. 7A to 7E are views for explaining a substrate swap operation;
Fig. 8 is a view showing a process of conveying a mold to a processor via the placement unit;
Fig. 9 is a view showing a process of conveying the mold to the processor without passing through the placement unit;
Fig. 10 is a view showing the configuration of a planarization apparatus;
Figs. 11A to 11D are views for explaining a planarization process; and
Fig. 12 is a view showing the configuration of the processor.

### DESCRIPTION OF THE EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

First, the outline of a planarization process will be described. The underlying pattern on a substrate has a concave-convex profile derived from a pattern formed in the previous step. In a case of a general logic process wafer, pattern-derived concave/convex portions of about 80 nm to 100 nm exist. The step derived from the moderate undulation of the entire substrate can be corrected by the focus tracking function of a scan exposure apparatus used in the photo step. However, the fine concave/convex portions having a pitch small enough to fall within the exposure slit area of the exposure apparatus cannot be corrected by the focus tracking function described above. If there are many concave/convex portions, they may fall outside the Depth Of Focus (DOF) of the exposure apparatus. As a conventional method of smoothing the underlying pattern of the substrate, a method of forming a planarized layer, such as Spin On Carbon (SOC) or Chemical Mechanical Polishing (CMP), is used. However, the conventional technique undesirably cannot obtain sufficient planarization performance, and the concave/convex difference of the underlayer by multilayer formation tends to increase.

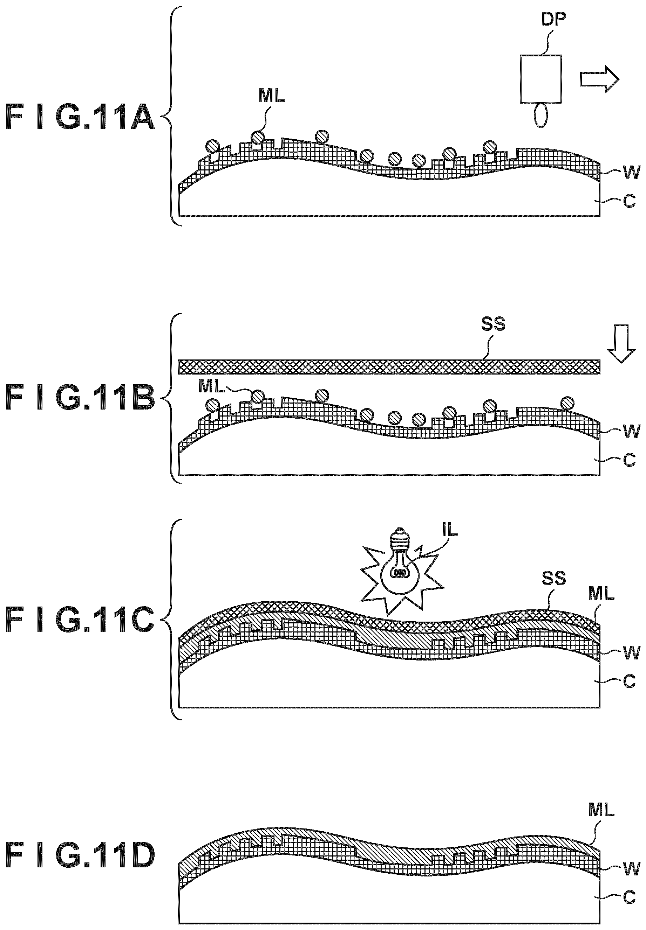

In order to solve this problem, studies have been conducted on a planarization apparatus that planarizes a substrate by applying a jet-and-flash imprint lithography (JFIL) technique. With reference to Figs. 11A to 11D, the outline of a planarization process using the JFIL technique will be described. In the planarization process using the JFIL technique, a substrate can be planarized through a supply step shown in Fig. 11A, a contact step shown in Fig. 11B, a curing step shown in Fig. 11C, and a separation step shown in Fig. 11D. In Figs. 11A to 11D, a circuit pattern has already been formed on the surface of a substrate W chucked by a substrate chuck C, and there can be pattern-derived concave/convex portions of, for example, about 80 nm to 100 nm. The requirement of the planarization apparatus according to this embodiment is to planarize the pattern-derived surface concave/convex portions.

In the supply step shown in Fig. 11A, a composition ML as a formable material is supplied from a dispenser DP to the surface of the substrate W chucked by the substrate chuck C. Note that in Fig. 11A, the composition ML is supplied from the dispenser DP to the surface of the substrate W on the substrate chuck C. However, in an embodiment to be described later, a supplier 109 as a module different from a processor that performs a planarization process supplies the composition ML.

In the contact step shown in Fig. 11B, a superstrate SS as a flat member (patternless member) having a flat surface with no pattern formed thereon and having an outer diameter equal to or larger than that of the substrate W is brought into contact with the composition ML. The superstrate is also called a "flat template". In this contact step, the superstrate SS is pressed against the entire region of the surface of the substrate W. With this, the composition ML spreads in a layer ("filling" or "spreading").

In the curing step shown in Fig. 11C, in a state in which the superstrate SS is in contact with the composition ML on the substrate W, the entire region of the surface of the substrate W is irradiated with ultraviolet light from a light source IL collectively (or by repeating partial exposure). With this, the composition ML spread in the layer is cured.

In the separation step shown in Fig. 11D, the superstrate SS is separated from the cured composition ML on the substrate W. Thus, the pattern-derived surface concave/convex portions of the substrate W are planarized. Note that it is not an object here to correct the flatness of a component with a low spatial frequency, such as the profile of the entire substrate distorted with respect to the absolute plane. For such a component, the non-planar component is compensated by the focus tracking control of an exposure apparatus in a subsequent pattern forming step.

In this manner, the planarization process with the imprint technique applied thereto is a technique of supplying a composition in accordance with the steps of a substrate, bringing a thin flat member called a superstrate into contact with the supplied composition, and curing the composition, thereby performing planarization on the nanometer order.

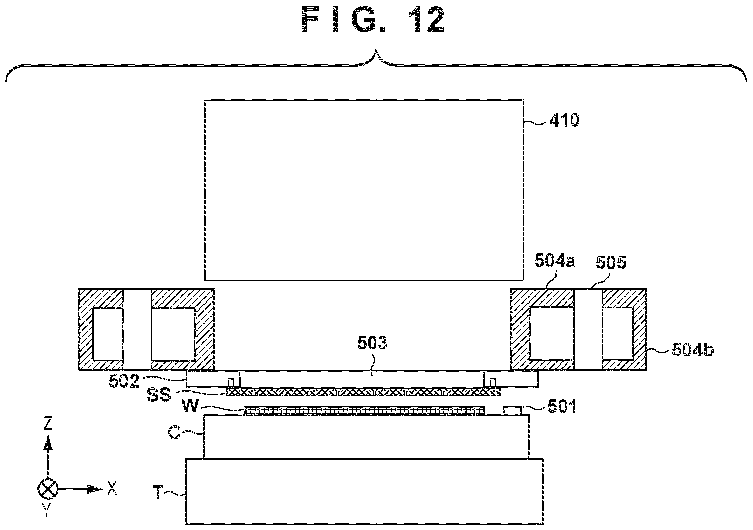

Fig. 12 is a view showing the configuration of a processor that performs a planarization process as described above. In the specification and the drawings, directions will be indicated on an XYZ coordinate system in which a horizontal plane is defined as the X-Y plane. The processor supports a substrate as a process target such that the surface of the substrate is parallel to the horizontal plane (X-Y plane). Therefore, in the following description, directions orthogonal to each other in a plane along the holding surface of the substrate in the processor are defined as the X-axis and the Y-axis, and the direction perpendicular to the X-axis and the Y-axis is defined as the Z-axis. Furthermore, in the following description, directions parallel to the X-axis, the Y-axis, and the Z-axis of the XYZ coordinate system are referred to as the X direction, the Y direction, and the Z direction, respectively, and a rotational direction around the X-axis, a rotational direction around the Y-axis, and a rotational direction around the Z-axis are referred to as the θX direction, the θY direction, and the θZ direction, respectively.

In Fig. 12, the superstrate SS is a flat member (patternless member), and can serve as a flat reference surface after the planarization process. In this embodiment, the substrate chuck C is mounted on a substrate stage T. On the substrate chuck C, sensors 501 that measure upward in the Z direction are arranged, for example, in two channels in the depth direction of the drawing surface. These sensors 501 can measure the Z-direction position and leveling (θX, θY) of the superstrate SS. Furthermore, by observing the edge portion of the superstrate SS while scanning the substrate stage T in the Y direction, these sensors 501 can measure the positional shift amount of the superstrate SS in the X and Y directions with respect to a chuck 502.

A cavity 503 partitioned by a transparent member with respect to an exposure light source (corresponding to the light source IL shown in Fig. 11C) included in an illumination/spread observation system 410 is formed above the superstrate SS. When bringing the superstrate SS into contact with the composition on the substrate W, the pressure in the cavity 503 is set to a positive pressure with respect to the atmospheric pressure. With this operation, the superstrate SS is formed into a convex shape with respect to the substrate W, so that it can first come into contact with the center of the substrate, thereby reducing the air trapped between the superstrate SS and the composition. A mover 504a of a linear motor is fixed to the chuck 502. The mover 504a can move with respect to a stator 504b of the linear motor via a spring hinge 505. The position of the linear motor arranged as described above is controlled using a position sensor (not shown). Three sets of the movers 504a, the stators 504b, the spring hinges 505, and the position sensors are mounted on one processor. With this configuration, in the contact step and the separation step, the chuck 502 is positioned with respect to three axes of Z, θX, and θY in accordance with a predetermined driving profile.

The illumination/spread observation system 410 is arranged above the superstrate SS. The illumination/spread observation system 410 can include an exposure light source, and an optical system for observing the spread state of the composition.

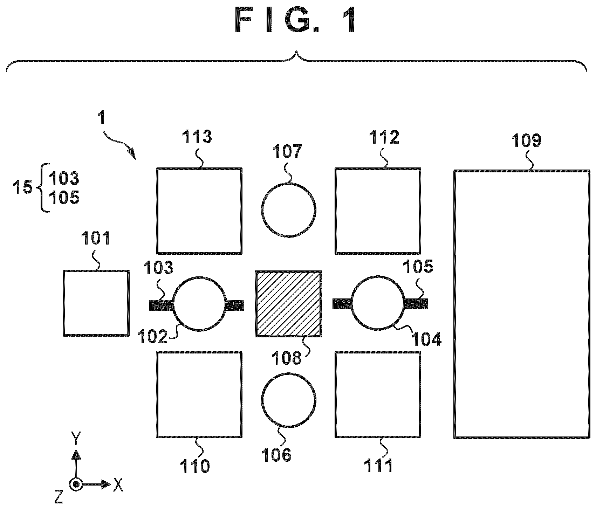

Fig. 1 is a view showing the configuration of a planarization apparatus 1 according to an embodiment. The planarization apparatus 1 has a cluster configuration in which a plurality of processors cooperate with each other. In the first embodiment, the planarization apparatus 1 includes four processors. Each of a first processor 110, a second processor 111, a third processor 113, and a fourth processor 112 can have the configuration shown in Fig. 12 described above.

The planarization apparatus 1 includes a loading unit 101 for loading a substrate or a flat member into the planarization apparatus. The loading unit 101 can be, for example, a relay unit to which a substrate conveyed from a substrate conveyance module also called an Equipment Front End Module (EFEM) is supplied. The loading unit 101 can include a substrate relay slot and a pre-alignment device that can relay a substrate. The pre-alignment device formed in the loading unit 101 performs pre-alignment of a substrate to be conveyed to the supplier 109.

The planarization apparatus 1 includes the supplier 109 that performs a supply process of supplying, to the substrate, a composition used for a planarization process. Details of the supplier 109 will be described later.

The planarization apparatus 1 includes, between one end at which the loading unit 101 is located and the other end at which the supplier 109 is located, a conveyance path 15 through which the substrate or the flat member is conveyed. In this embodiment, the conveyance path 15 is formed by a first conveyance path 103 and a second conveyance path 105 each of which extends in the X direction.

The planarization apparatus 1 includes a placement unit 108 arranged in the middle on the conveyance path. The placement unit 108 is configured to place the substrate or the flat member to be loaded to one of the plurality of processors. In this embodiment, the placement unit 108 is arranged between the first conveyance path 103 and the second conveyance path 105. The placement unit 108 is also configured to perform pre-alignment of the placed substrate. In an example, the placement unit 108 can include a substrate relay slot and a pre-alignment device that can relay a substrate. The pre-alignment device formed in the placement unit 108 performs pre-alignment of the substrate to be conveyed to one of the processors. Therefore, the placement unit 108 is not just a placement unit, and serves as an adjuster having a substrate pre-alignment function.

The planarization apparatus 1 includes a first conveyance robot 102 as a conveyance mechanism for conveying the substrate or the flat member. The first conveyance robot 102 is arranged on the conveyance path between the loading unit 101 and the placement unit 108, and is configured to convey the substrate or the flat member. The first conveyance robot 102 is mounted on the first conveyance path 103, and can convey the substrate by moving on the first conveyance path 103 even if the distance between the loading unit 101 and the placement unit 108 is large.

The planarization apparatus 1 includes a second conveyance robot 104. The second conveyance robot 104 is arranged on the conveyance path between the placement unit 108 and the supplier 109, and is configured to convey the substrate or the flat member. The second conveyance robot 104 is mounted on the second conveyance path 105, and can convey the substrate by causing the second conveyance robot 104 to move on the second conveyance path 105 even if the distance between the placement unit 108 and the supplier 109 is large.

Note that the effective strokes of the first conveyance path 103 and the second conveyance path 105 may be different from each other. However, the time required to move the maximum stroke of each conveyance path needs to be within the time required by the conveyance robot to make a 180° turn. This is because if the moving time of each conveyance path is longer than the turning time of the conveyance robot, the throughput of the apparatus decreases.

The first processor 110 is arranged within the conveyance range of the substrate or the flat member by the first conveyance robot 102. This conveys the substrate or the flat member from the first conveyance robot 102 to the first processor 110. The second processor 111 is arranged within the conveyance range of the substrate or the flat member by the second conveyance robot 104. This conveys the substrate or the flat member from the second conveyance robot 104 to the second processor 111.

In this embodiment, the first conveyance robot 102 is configured to convey the substrate or the flat member among the loading unit 101, the placement unit 108, and the first processor 110. The second conveyance robot 104 is configured to convey the substrate or the flat member among the placement unit 108, the supplier 109, and the second processor 111.

The planarization apparatus 1 further includes a third conveyance robot 106. The third conveyance robot 106 is configured to convey the substrate or the flat member among the first processor 110, the second processor 111, and the placement unit 108.

In this embodiment, the third processor 113 is arranged within the conveyance range of the substrate or the flat member by the first conveyance robot 102, and the fourth processor 112 is arranged within the conveyance range of the substrate or the flat member by the second conveyance robot 104. The planarization apparatus 1 can also include a fourth conveyance robot 107 configured to convey the substrate or the flat member among the third processor 113, the fourth processor 112, and the placement unit 108.

The supplier 109 supplies a composition as a formable material to the surface of the substrate. The supplier 109 can include a stage that moves while holding the substrate, and a dispenser that dispenses the composition. The dispenser can be a jetting module configured to supply the composition in a state of droplets. The composition is supplied to the entire surface of the substrate by relatively scanning and driving the stage and the dispenser a plurality of times. At this time, the composition can be supplied while applying the supply amount distribution of the composition in accordance with the arrangement of the concave/convex pattern formed on the surface of the substrate and the like. For example, the composition is supplied such that the droplet density is high for a portion where the ratio of the concave portion of the pattern on the substrate surface is high, and the droplet density is low for a portion where the ratio of the concave portion is low. To do this, when the composition is supplied by the dispenser, substrate alignment measurement can be performed to preliminarily match the position of the pattern formed on the substrate with the position of the density pattern of the composition to be supplied.

In this embodiment, as shown in Fig. 1, the loading unit 101, the placement unit 108, and the supplier 109 are arranged in a row on the conveyance path. The first processor 110 and the second processor 111 are arrayed in a row in a direction parallel to the direction (X direction) in which the conveyance path extends. Fig. 1 is a planar view of the planarization apparatus 1 when viewed from above in the Z direction. In a side view when viewed from the Y direction, it will be understood that the first processor 110 is arranged at a position between the loading unit 101 and the placement unit 108. In the side view, it will also be understood that the second processor 111 is arranged at a position between the placement unit 108 and the supplier 109.

The third processor 113 and the fourth processor 112 are arranged on the opposite side of the first processor 110 and the second processor 111 across the conveyance path. In this embodiment, the third conveyance robot 106 and the fourth conveyance robot 107 are arranged in a row in a direction intersecting the conveyance path at the position where the placement unit 108 is arranged. That is, the third conveyance robot 106 and the fourth conveyance robot 107 are arranged in a row in the Y direction so as to sandwich the placement unit 108 therebetween. In this case, the third conveyance robot 106 is arranged between the first processor 110 and the second processor 111, and the fourth conveyance robot 107 is arranged between the third processor 113 and the fourth processor 112.

A planarization process in each of the first processor 110, the second processor 111, the third processor 113, and the fourth processor 112 will be described. In the contact step, each processor presses the superstrate SS against the entire region of the surface of the substrate by bringing the superstrate SS having an outer diameter equal to or larger than that of the substrate into contact with the composition, thereby spreading the composition in a layer. In the curing step, the composition is cured while the superstrate SS is in contact with the composition on the substrate. The composition can be a photo-curable composition cured by ultraviolet light emitted from a light source (included in the illumination/spread observation system 410). In the separation step, the superstrate SS is separated from the cured composition on the substrate. This planarizes the surface of the substrate.

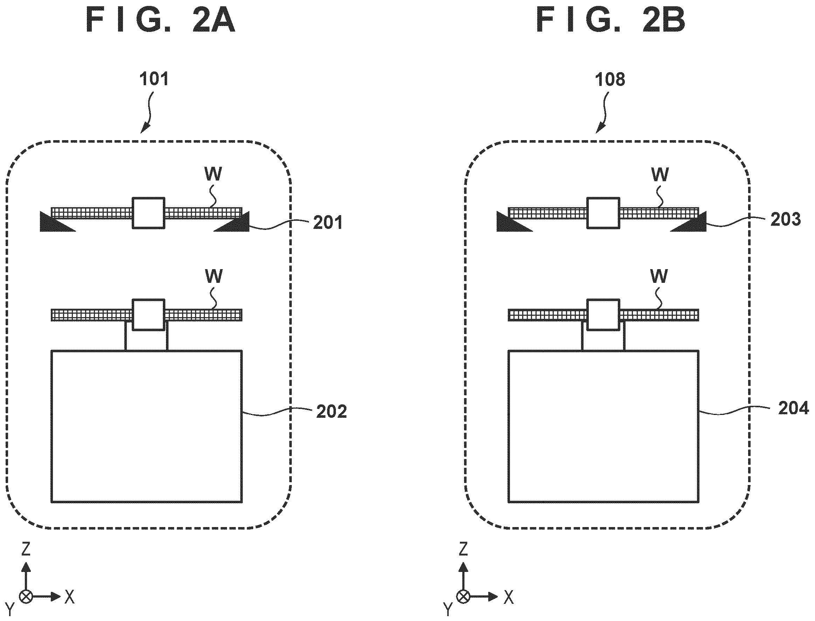

The configurations of the loading unit 101 and the placement unit 108 will be described with reference to Figs. 2A and 2B. Fig. 2A is a view showing the configuration of the loading unit 101, and Fig. 2B is a view showing the configuration of the placement unit 108. The loading unit 101 can include a substrate placement portion 201 on which a substrate is placed, and a pre-alignment device 202 arranged below the substrate placement portion 201 and configured to perform pre-alignment of the substrate placed on the substrate placement portion 201. The placement unit 108 can include a substrate placement portion 203 on which a substrate is placed, and a pre-alignment device 204 arranged below the substrate placement portion 203 and configured to perform pre-alignment of the substrate placed on the substrate placement portion 203. In each of the loading unit 101 and the placement unit 108, a plurality of shelves that can store a plurality of substrates may be provided. The numbers of substrates (the numbers of shelves) that can be stored in the loading unit 101 and the placement unit 108 may be the same or different. Note that a substrate is assumed to be placed on each of the loading unit 101 and the placement unit 108 but the superstrate SS may be placed. The pre-alignment devices 202 and 204 may have the same configuration or different configurations. In each of the loading unit 101 and the placement unit 108, the arrangement of the substrate placement portion and the pre-alignment device may be inverted.

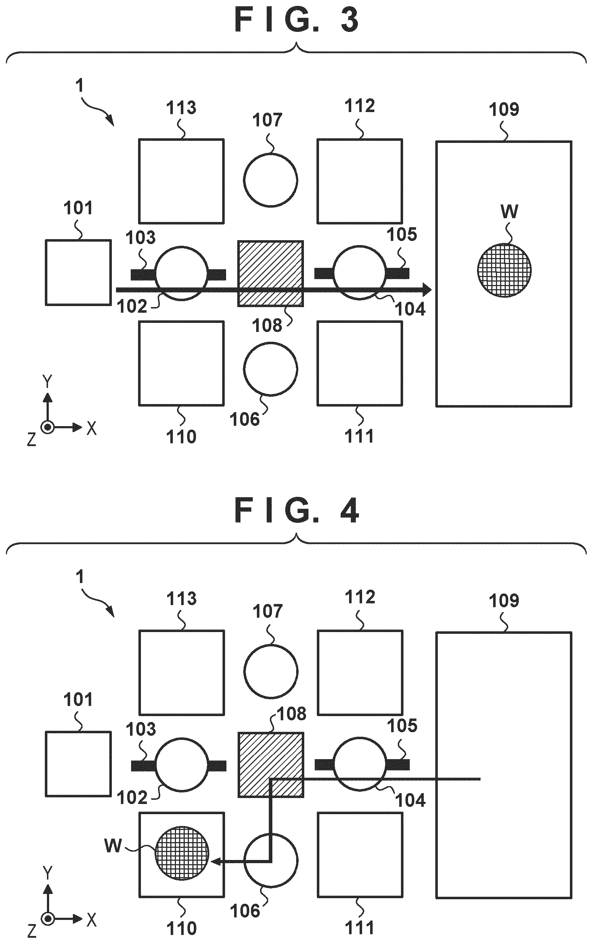

A process of conveying the substrate W from the loading unit 101 to the supplier 109 will be described with reference to Fig. 3. First, the substrate W is conveyed to the loading unit 101. At this time, the substrate W is placed on the pre-alignment device 202 of the loading unit 101. The pre-aligned substrate W is placed on the substrate placement portion 203 of the placement unit 108 by the first conveyance robot 102. Subsequently, the substrate W placed on the placement unit 108 is conveyed to the supplier 109 by the second conveyance robot 104. The supplier 109 performs a supply process of supplying (dispensing) the formable material to the loaded substrate W.

A process of conveying the substrate W from the supplier 109 to the first processor 110 will be described with reference to Fig. 4. The substrate W having undergone the supply process by the supplier 109 is placed on the pre-alignment device 204 of the placement unit 108 by the second conveyance robot 104. The third conveyance robot 106 receives the substrate W pre-aligned by the pre-alignment device 204, and conveys it to the first processor 110, thereby performing a planarization process. The third conveyance robot 106 can convey a succeeding substrate to the second processor 111. The substrate is conveyed to the third processor 113 and the fourth processor 112 by the fourth conveyance robot 107.

Note that when conveying the substrate from the supplier 109 to the second processor 111, the second conveyance robot 104 conveys the substrate from the supplier 109 to the second processor 111 without passing through the placement unit 108.

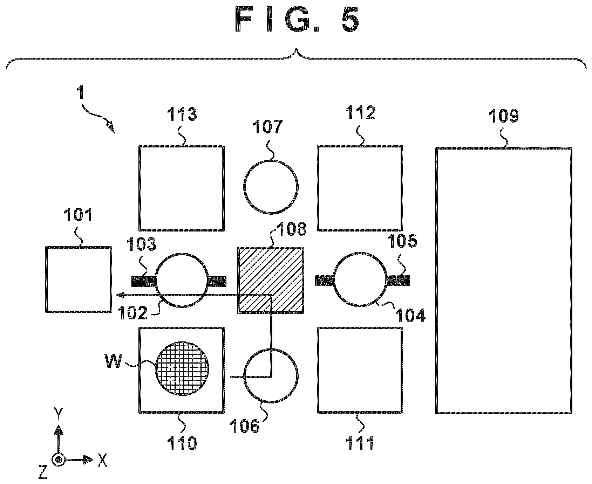

A process of conveying the substrate W from the first processor 110 to the loading unit 101 will be described with reference to Fig. 5. The substrate W processed by the first processor 110 is conveyed to the substrate placement portion 203 of the placement unit 108 by the third conveyance robot 106. Subsequently, the substrate W placed on the substrate placement portion 203 is conveyed to the substrate placement portion 201 of the loading unit 101 by the first conveyance robot 102, and then unloaded outside the apparatus.

Figs. 3 to 5 show the processes of conveying the specific one substrate W. Next, a process of continuously conveying a plurality of substrates will be described.

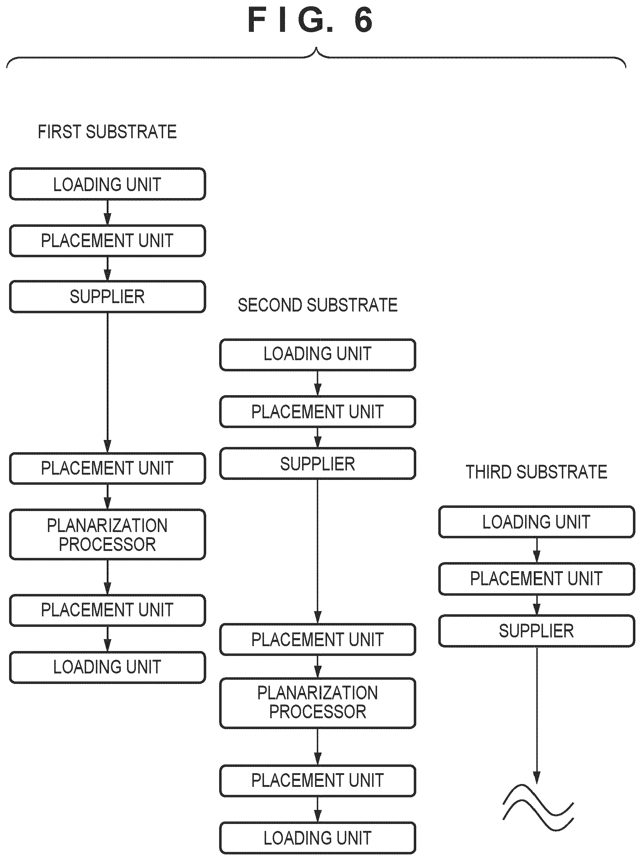

Fig. 6 is a timing chart of conveyance of a plurality of substrates. For example, one substrate is conveyed to the loading unit 101, the placement unit 108, the supplier 109, the placement unit 108, the first processor 110, the placement unit 108, and the loading unit 101 in this order, as described above. When the first substrate is loaded to the supplier 109, the second substrate is placed on the loading unit 101. When the second substrate is loaded to the supplier 109, the dispense process of the first substrate ends. Each of the first conveyance robot 102, the second conveyance robot 104, the third conveyance robot 106, and the fourth conveyance robot 107 has two hands for holding a substrate. Therefore, for example, since each of the third conveyance robot 106 and the fourth conveyance robot 107 can hold a substrate to be unloaded from the processor while holding a substrate to be loaded to the processor, a substrate swap operation is possible. Details of the substrate swap operation will be described later. Thus, the substrate swap operation is performed when the second substrate is loaded to the supplier 109. This can recover the first substrate from the supplier 109. The recovered first substrate is conveyed to the first processor 110. The number of substrates processed per unit time of the supplier 109 is twice or more the number of substrates processed per unit time of each of the plurality of processors. In an example, the processing time per substrate of the supplier 109 is 1/4 or less of the processing time per substrate of each of the first processor 110, the second processor 111, the third processor 113, and the fourth processor 112. Therefore, while the first processor 110 performs the planarization process of the first substrate, the second substrate having undergone the supply process by the supplier 109 is conveyed to the second processor 111. While the second processor 111 performs the planarization process of the second substrate, the third substrate having undergone the supply process by the supplier 109 is conveyed to the fourth processor 112. While the fourth processor 112 performs the planarization process of the third substrate, the fourth substrate having undergone the supply process by the supplier 109 is conveyed to the third processor 113. When the fifth substrate is conveyed to the first processor 110, the planarization process of the first substrate ends, and the first substrate is recovered by the substrate swap operation. In this way, the plurality of substrates are continuously conveyed.

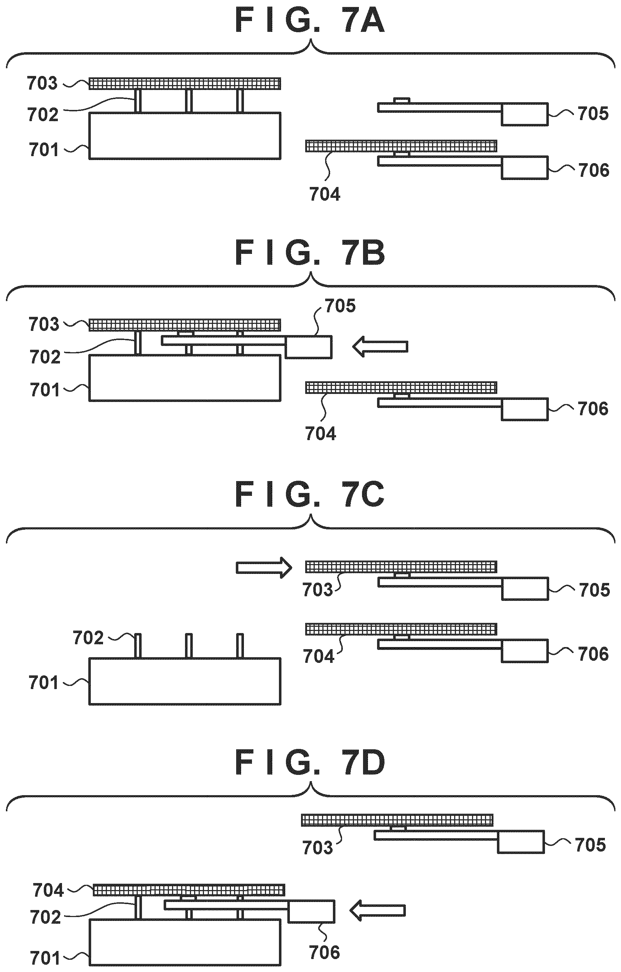

Details of the substrate swap operation will be described with reference to Figs. 7A to 7E. Figs. 7A to 7E are views showing a procedure of recovering, by using two hands, a first substrate 703 having undergone the supply process by the supplier 109 and placing a second substrate 704. The supplier 109 includes a substrate chuck 701 and liftup pins 702 that protrude from the chuck surface of the substrate chuck 701 and are sunk in the chuck surface by an elevating mechanism. The conveyance robot (second conveyance robot 104) has two hands 705 and 706. The two hands 705 and 706 are stacked in the height direction (Z direction).

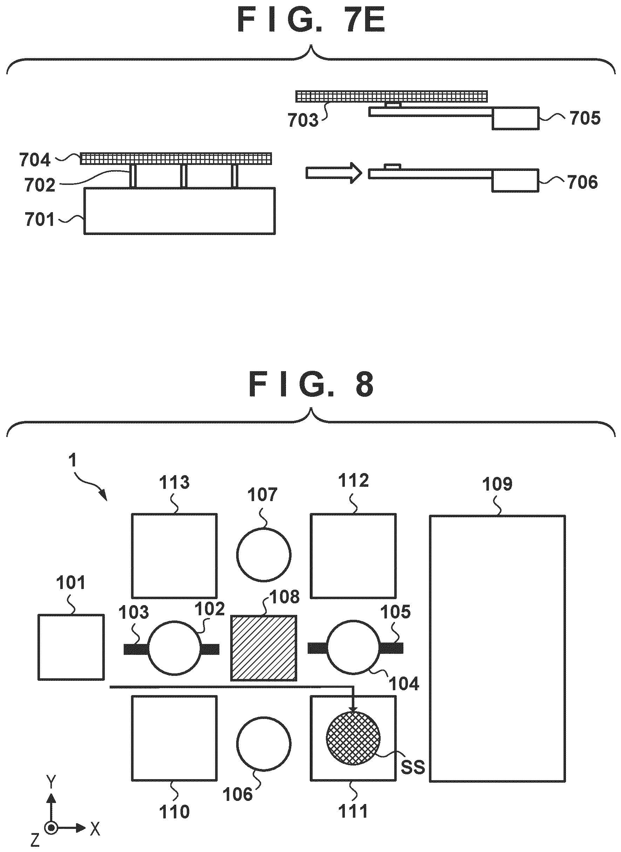

The first substrate 703 having undergone the supply process by the supplier 109 is lifted up by the liftup pins 702 and isolated from the substrate chuck 701. At this time, the hand 705 holds no substrate since it is used as a substrate recovery hand, and the hand 706 holds the second substrate 704 since it is used as a substrate placement hand (Fig. 7A). The hand 705 enters under the first substrate 703 lifted up from the substrate chuck 701 (Fig. 7B). After that, the hand 705 holds and recovers the first substrate 703 (Fig. 7C). Subsequently, the hand 706 that holds the second substrate 704 enters above the substrate chuck 701 (Fig. 7D). Then, the hand 706 places the second substrate 704 on the liftup pins 702, and then retreats (Fig. 7E). With the series of operations, the substrate swap operation is performed.

Note that the vertical positions of the hands 705 and 706 may be reversed. The above example has explained the substrate swap operation in the supplier 109 by the second conveyance robot 104 but the substrate swap operation can be performed in the same manner in each of the first processor 110, the second processor 111, the third processor 113, and the fourth processor 112.

The superstrate SS used for the planarization process in each of the first processor 110, the second processor 111, the third processor 113, and the fourth processor 112 can be exchanged every time a predetermined number of substrates are planarized. This is because the surface of the superstrate SS that contacts the formable material may be contaminated by the formable material or the like to cause defects on the substrate surface at the time of the planarization process. To convey the superstrate SS, the first conveyance robot 102 and the second conveyance robot 104 that are the same as those used to convey the substrate can be used. It has been described that each of the first to fourth conveyance robots has two hands for holding a substrate. In addition to them, each of the first to fourth conveyance robots may have one hand for conveying the superstrate SS.

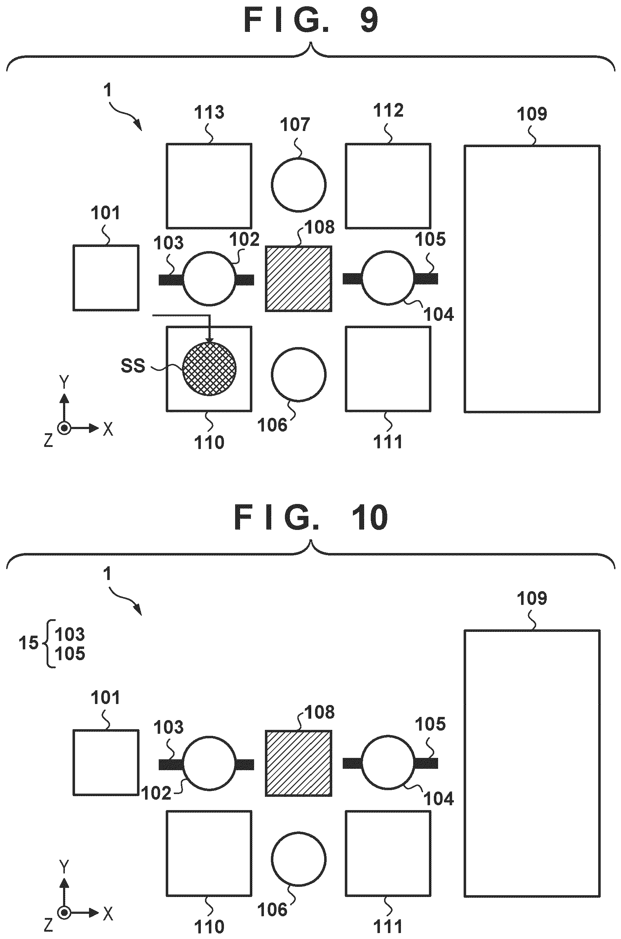

A conveyance process of the superstrate SS will be described with reference to Figs. 8 and 9. Fig. 8 shows a process of conveying the superstrate SS to the second processor 111 via the placement unit 108. The superstrate SS loaded from the loading unit 101 is placed on the pre-alignment device 202 of the loading unit 101. The superstrate SS pre-aligned by the pre-alignment device 202 is placed on the substrate placement portion 203 of the placement unit 108 by the first conveyance robot 102. Subsequently, the second conveyance robot 104 receives the superstrate SS from the placement unit 108, and conveys the superstrate SS to the second processor 111. Another superstrate to be conveyed to the fourth processor 112 can be conveyed in the same manner.

Fig. 9 shows a process of conveying the superstrate SS to the first processor 110 without passing through the placement unit 108. The superstrate SS pre-aligned by the pre-alignment device 202 of the loading unit 101 is conveyed to the first processor 110 by the first conveyance robot 102. Another superstrate to be conveyed to the third processor 113 can be conveyed in the same manner. In this way, in a case where the conveyance destination of the superstrate SS is the first processor 110 or the third processor 113, the first conveyance robot 102 conveys the superstrate SS from the loading unit 101 to the first processor 110 without passing through the placement unit 108.

### <Second Embodiment>

A planarization apparatus 1 according to the second embodiment will be described with reference to Fig. 10. In the first embodiment (Fig. 1), the planarization apparatus 1 includes four processors. On the other hand, in the second embodiment (Fig. 10), the planarization apparatus 1 includes two processors. In this embodiment, the two processors are a first processor 110 and a second processor 111. In this case, conveyance of a substrate between a placement unit 108 and the first processor 110 and between the placement unit 108 and the second processor 111 is performed by a third conveyance robot 106, similar to the first embodiment. In this embodiment, the planarization apparatus 1 includes neither the third processor 113 nor the fourth processor 112, and thus includes no fourth conveyance robot 107.

Note that the configurations of a loading unit 101 and the placement unit 108 are the same as in the first embodiment. Therefore, in this embodiment as well, conveyance of a substrate between the loading unit 101 and the placement unit 108 is performed by a first conveyance robot 102, and conveyance of a substrate between the placement unit 108 and a supplier 109 is performed by a second conveyance robot 104.

As described in the first embodiment, the number of substrates processed per unit time of the supplier 109 is twice or more the number of substrates processed per unit time of each of the plurality of processors. However, in the second embodiment, the number of substrates loaded per unit time and the number of superstrates loaded per unit time are different from the first embodiment. As described above, the processing time per substrate of the supplier 109 is 1/4 or less of the processing time per substrate of each of the first processor 110 and the second processor 111. Consequently, if the number of substrates loaded per unit time is the same as in the first embodiment, the number of processed substrates of each of the first processor 110 and the second processor 111 is smaller than the number of processed substrates of the supplier 109 and thus substrate conveyance is delayed. Therefore, in the second embodiment, the number of substrates loaded per unit time is half of that in the first embodiment. By using the above-described conveyance method, it is possible to continuously process substrates.

### <Embodiment of Article Manufacturing Method>

A method of manufacturing an article (a semiconductor IC element, a liquid crystal display element, a color filter, a MEMS, or the like) by using the above-described planarization apparatus will be described next. The manufacturing method includes, by using the above-described planarization apparatus, a step of planarizing a composition by bringing the composition arranged on a substrate (a wafer, a glass substrate, or the like) and a superstrate into contact with each other, a step of curing the composition, and a step of separating the composition and the superstrate from each other. With this, a planarized film is formed on the substrate. Then, processing such as pattern formation using a lithography apparatus is performed on the substrate with the planarized film formed thereon, and the processed substrate is processed in other known processing steps to manufacture an article. Other known steps include patterning exposure and accompanying preprocessing, etching, resist removal, dicing, bonding, packaging, and the like. This manufacturing method can manufacture an article with higher quality than the conventional methods.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. A planarization apparatus (1) comprising a plurality of processors including a first processor (110) and a second processor (111) and configured to perform a planarization process of a substrate using a flat member (SS) in each of the plurality of processors, the apparatus **characterized by** comprising:
a loading unit (101) configured to load one of a substrate and a flat member into the planarization apparatus;
a supplier (109) configured to perform a supply process of supplying, to the substrate, a composition used for the planarization process;
a conveyance path (15) through which one of the substrate and the flat member is conveyed between one end at which the loading unit is located and the other end at which the supplier is located;
an adjuster (108) arranged in the middle on the conveyance path and configured to place one of the substrate and the flat member to be loaded to one of the plurality of processors and perform pre-alignment of the placed substrate;
a first conveyance robot (102) arranged on the conveyance path between the loading unit and the adjuster and configured to convey one of the substrate and the flat member; and
a second conveyance robot (104) arranged on the conveyance path between the adjuster and the supplier and configured to convey one of the substrate and the flat member,
wherein the first processor is arranged within a conveyance range of one of the substrate and the flat member by the first conveyance robot, and
the second processor is arranged within a conveyance range of one of the substrate and the flat member by the second conveyance robot.

2. The apparatus according to claim 1, **characterized in that**
the first conveyance robot is configured to convey one of the substrate and the flat member among the loading unit, the adjuster, and the first processor, and
the second conveyance robot is configured to convey one of the substrate and the flat member among the adjuster, the supplier, and the second processor.

3. The apparatus according to claim 2, **characterized by** further comprising a third conveyance robot (106) configured to convey one of the substrate and the flat member and configured to convey one of the substrate and the flat member among the first processor, the second processor, and the adjuster.

4. The apparatus according to claim 3, **characterized in that**
the plurality of processors further include
a third processor (113) arranged within the conveyance range of one of the substrate and the flat member by the first conveyance robot, and
a fourth processor (112) arranged within the conveyance range of one of the substrate and the flat member by the second conveyance robot, and
the planarization apparatus further comprises a fourth conveyance robot (107) configured to convey one of the substrate and the flat member among the third processor, the fourth processor, and the adjuster.

5. The apparatus according to claim 4, **characterized in that** the loading unit, the adjuster, and the supplier are arranged in a row on the conveyance path.

6. The apparatus according to claim 5, **characterized in that**
the first processor and the second processor are arrayed in a row in a direction parallel to a direction in which the conveyance path extends,
the first processor is arranged at a position between the loading unit and the adjuster in a side view of the planarization apparatus, and
the second processor is arranged at a position between the adjuster and the supplier in the side view.

7. The apparatus according to claim 6, **characterized in that** the third processor and the fourth processor are arranged on an opposite side of the first processor and the second processor across the conveyance path.

8. The apparatus according to claim 7, **characterized in that**
the third conveyance robot and the fourth conveyance robot are arranged in a row in a direction intersecting the conveyance path at a position where the adjuster is arranged,
the third conveyance robot is arranged between the first processor and the second processor, and
the fourth conveyance robot is arranged between the third processor and the fourth processor.

9. The apparatus according to claim 6, **characterized in that** in a case where the substrate is conveyed from the supplier to the second processor, the second conveyance robot conveys the substrate from the supplier to the adjuster and places the substrate, and the third conveyance robot receives the substrate at the adjuster and conveys the substrate to the first processor.

10. The apparatus according to claim 6, **characterized in that** in a case where the substrate is conveyed from the supplier to the second processor, the second conveyance robot conveys the substrate from the supplier to the second processor without passing through the adjuster.

11. The apparatus according to claim 6, **characterized in that** in a case where the flat member is conveyed from the loading unit to the second processor, the first conveyance robot conveys the flat member from the loading unit to the adjuster and places the flat member, and the second conveyance robot receives the flat member at the adjuster and conveys the flat member to the second processor.

12. The apparatus according to claim 6, **characterized in that** in a case where the flat member is conveyed from the loading unit to the first processor, the first conveyance robot conveys the flat member from the loading unit to the first processor without passing through the adjuster.

13. The apparatus according to claim 1, **characterized in that** the first conveyance robot includes two hands configured to hold a substrate and one hand configured to hold a flat member.

14. The apparatus according to claim 1, **characterized in that** the number of substrates processed per unit time of the supplier is not less than twice the number of substrates processed per unit time of each of the plurality of processors.

15. The apparatus according to claim 1, **characterized in that** for the substrate conveyed from the loading unit, the supplier performs the supply process and one of the processors performs the planarization process, and then the substrate is returned to the loading unit.

16. The apparatus according to claim 1, **characterized in that** the adjuster includes a plurality of shelves configured to store a plurality of substrates or flat members.

17. The apparatus according to claim 1, **characterized in that** the planarization process is performed by bringing the flat member into contact with the composition supplied onto the substrate by the supplier and thus forming a planarized film by the composition on the substrate.

18. An article manufacturing method **characterized by** comprising:
forming a planarized film on a substrate using a planarization apparatus defined in any one of claims 1 to 17; and
processing the substrate with the planarized film formed thereon,
wherein an article is manufactured from the processed substrate.
